# FASCICULE DE BREVET EUROPEEN

(11) **EP 2 713 508 B1**
(45) Date de publication et mention de la délivrance du brevet: **30.09.2020**
(21) Numéro de dépôt: 13185584.3
(22) Date de dépôt: 23.09.2013
(51) Int. Cl.: H03H 3/04, H03H 9/05, H03H 9/17, H03H 9/54, H03H 9/58

(54) **Structure acoustique comportant au moins un résonateur et au moins une capacité cointégrée dans une même couche piézoélectrique ou ferroélectrique**
Akustische Struktur, die mit mindestens einem Resonator und mindestens einer in dieselbe piezo- oder ferroelektrische Schicht kointegrierten Kapazität ausgestattet ist
Acoustic structure comprising at least one resonator and at least one capacitor jointly built into a single piezoelectric or ferroelectric layer

(30) Priorité: 27.09.2012 FR 1259071
(43) Date de publication de la demande: 02.04.2014
(73) Titulaire: COMMISSARIAT À L'ÉNERGIE ATOMIQUE ET AUX ÉNERGIES ALTERNATIVES, 75015 Paris (FR)
(72) Inventeur: Reinhardt, Alexandre, 38400 Saint Martin d'Heres (FR); Abergel, Julie, 38000 Grenoble (FR); David, Jean-Baptiste, 38000 Grenoble (FR)
(74) Mandataire: Esselin, Sophie

(56) Documents cités:
- WO-A1-01/78230
- US-A1- 2002 021 192
- US-A1- 2002 186 102
- US-A1- 2011 316 649

## Description

La présente invention se rapporte aux composants acoustiques pour le traitement analogique de signaux électroniques, et tout particulièrement à des résonateurs et des filtres présentant de très faibles pertes ainsi qu'une grande compacité.

Actuellement, les circuits inclus dans les systèmes de communication sans fil doivent être capables de gérer de nombreux modes de fonctionnement. Avec la multiplication des normes de communication, les terminaux de communication doivent être capables d'utiliser le réseau disponible le plus approprié, quelle que soit la localisation physique. Les normes de communications différant sur des aspects tels que la modulation du signal ou la largeur des canaux, les circuits doivent présenter une grande flexibilité.

Cette flexibilité est tout naturellement amenée par le traitement numérique du signal effectué grâce à des DSP (*Digital Signal Processing*) dans lequel différents algorithmes peuvent être implémentés sous la forme de programmes et ainsi choisis librement par le système lui-même en fonction des conditions d'utilisation. Par contraste, la partie analogique des circuits est plus spécifique à une tâche donnée, et plus difficile à adapter à différentes conditions. C'est pourquoi les concepteurs de systèmes font le choix de convertir au plus tôt les signaux dans le domaine numérique. A cette fin, le signal peut être digitalisé en fréquence intermédiaire (c'est-à-dire après une première conversion de la fréquence porteuse du signal du domaine radiofréquence - c'est-à-dire de 700 MHz à 2.5 GHz - à des fréquences de l'ordre de quelques dizaines à quelques centaines de MHz) comme décrit dans l'article de T.O. Salo, S.J. Lindfors, T.M. Hollman, J.A.L. Järvinen et K.A.I. Halonen, 80-MHz bandpass ΔΣ modulators for multimode digital IF receivers, IEEE. J. of Solid-State Circuits, vol. 38, n°3, p. 464 (2003) plutôt qu'en bande de base (après suppression de la porteuse du signal).

Un modulateur ΔΣ à bande passante réalise cette conversion analogique/numérique d'un signal à haute fréquence avec une haute résolution, en faisant un bon candidat pour une digitalisation directe en fréquence intermédiaire.

Un modulateur ΔΣ à bande passante réalise une conversion d'un signal analogique à haute fréquence vers le numérique avec une haute résolution, et uniquement sur une bande de fréquence étroite, ce qui le rend particulièrement adapté à la numérisation d'un signal modulé. De plus, l'opération d'échantillonnage peut également être utilisée pour diminuer une seconde fois la fréquence du signal. Ceci permet de diminuer les contraintes apportées à la fréquence d'horloge du modulateur, qui sans cela devrait fonctionner au moins à trois ou quatre fois plus haute fréquence que la fréquence intermédiaire visée. Après conversion vers le domaine numérique, le signal est converti numériquement en bande de base et démodulé.

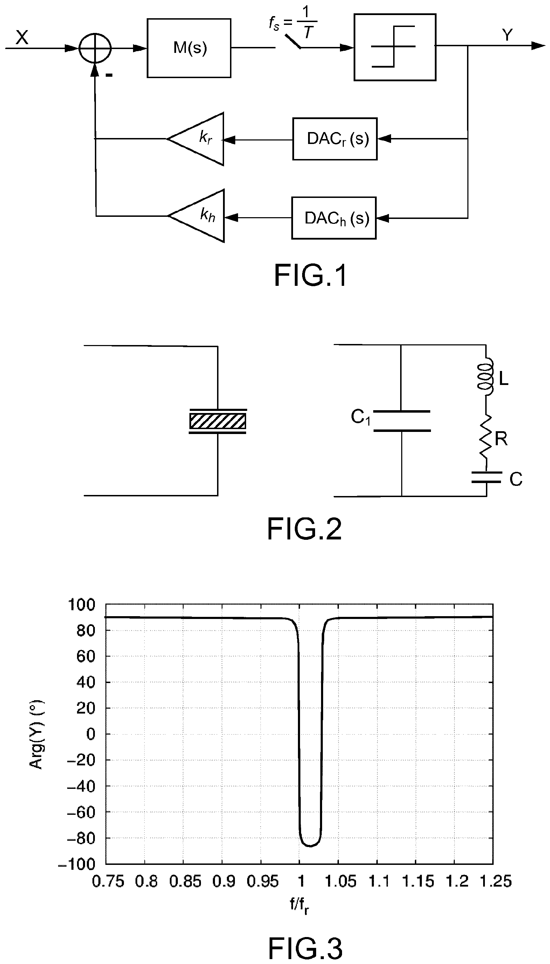

Les modulateurs ΔΣ à bande passante sont habituellement limités par les faibles coefficients de qualité et les non linéarités introduites par les résonateurs à éléments passifs discrets LC ou utilisant un transistor couplé à une capacité (Gm-C). Pour pallier ces limitations, il a été proposé d'utiliser des résonateurs à quartz, des résonateurs électromécaniques comme décrit dans l'article de X. Wang, Y.P. Xu, Z. Wang, S. Liw, W.H. Sun, L.S. Tan, A bandpass sigma-delta modulator employing micro-mechanical resonator, Proceedings of the 2003 International Symposium on Circuits and Systems (ISCAS'03), p. I-1041 (2003), des résonateurs à ondes acoustiques de surface (R. Yu et Y.P. Xu, Bandpass Sigma-Delta modulator employing SAW resonator as loop filter, IEEE Trans. On Circuits and Systems I: Fundamental theory and applications, vol. 54, p. 723 (2007), voire même des résonateurs à ondes de Lamb (M. Desvergne, P. Vincent, Y. Deval et J.B. Bégueret, RF Lamb wave resonators in bandpass delta-sigma converters for digital receiver architectures, IEEE Northeast workshop on Circuits and Systems (NEWCAS 2007), p. 449 (2007), qui se distinguent par leurs coefficients de qualité de l'ordre de 1000. Le schéma d'un tel convertisseur est donné en figure 1, il s'agit plus précisément d'un système de réception utilisant un convertisseur analogique-numérique à bande passante, et incluant un résonateur M(s) sur le circuit.

Tous ces composants présentent une réponse électrique qui en première approximation peut être approximée par le schéma dit de Butterworth-Van Dyke (BVD) comme décrit dans l'article de K.S. Van Dyke, The piezo-electric resonator and its equivalent network, Proc. IRE, vol. 16, p. 742 (1928) et représenté sur la figure 2 illustrant ce schéma équivalent à un résonateur électromécanique ou acoustique.

Intrinsèquement, ce type de composants présente des variations de la phase de leur admittance allant de 90° (comportement capacitif avant la résonance et après l'antirésonance) à -90° (comportement inductif entre la résonance et l'antirésonance), comme illustré sur la figure 3, avec deux passages à zéro de la phase, le premier à la résonance et le second à l'antirésonance. Ainsi, deux conditions d'accord de la boucle de contre-réaction sont possibles, ce qui conduit à une instabilité du circuit ((M. Desvergne, P. Vincent, Y. Deval et J.B. Bégueret, RF Lamb wave resonators in bandpass delta-sigma converters for digital receiver architectures, IEEE Northeast workshop on Circuits and Systems (NEWCAS 2007), p. 449 (2007). Pour éviter ceci, et se ramener à un résonateur présentant la même fonction de transfert qu'un résonateur de type LC habituel, il est nécessaire de compenser la capacité statique C₁ représentée en figure 2, du résonateur.

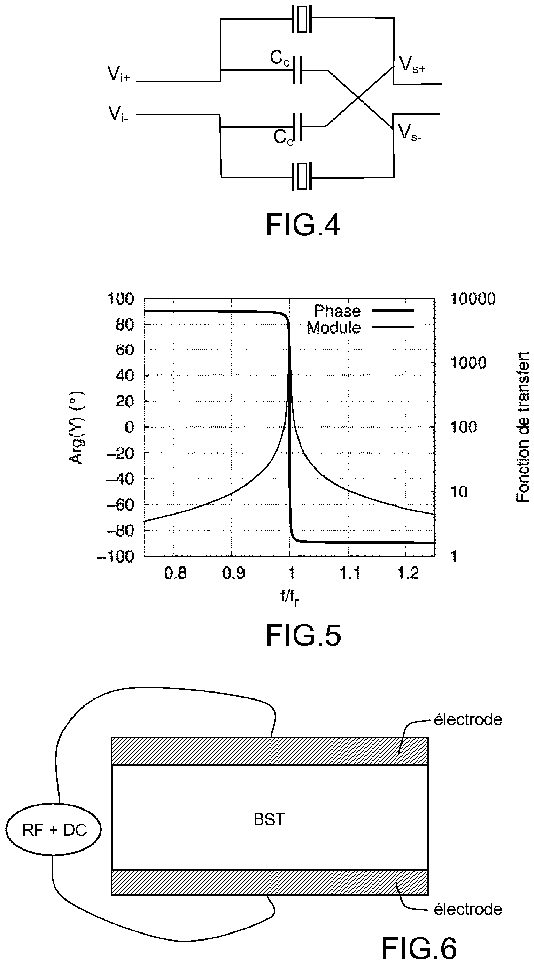

La compensation de la capacité statique du résonateur peut se faire en construisant un pont de capacités tel qu'illustré sur la figure 4. Ce circuit présente en pratique l'équivalent d'une capacité C_{c} négative mise en parallèle avec chaque résonateur. Pour que la compensation soit complète, il faut donc que la capacité C_{c} soit appariée avec la capacité statique C₁ du résonateur. On génère alors la fonction de transfert illustrée en figure 5 qui ne présente plus qu'une seule résonance.

D'un point de vue pratique, la réalisation des modulateurs sigma-delta est sujette à des dispersions de fabrication, qui se traduisent par des dispersions sur la valeur de la capacité statique C₁ du résonateur. A l'heure actuelle, la réalisation d'un tel circuit avec une capacité exactement appariée à la capacité statique du résonateur reste problématique. Plus généralement, ce type de problème se pose dans le cas où l'on a besoin de recourir, dans un circuit composé d'éléments hétérogènes (c'est-à-dire utilisant chacun une technologie différente), à des valeurs de capacités qui doivent être rigoureusement appariées à des valeurs de capacités rencontrées dans d'autres modules du circuit. La solution généralement adoptée est de recourir à un tri des composants par valeurs et à n'assembler ensemble que ceux qui ont des valeurs proches, ou à utiliser des éléments variables permettant de compenser des dérives. Toutes ces solutions se révèlent coûteuses puisqu'elles nécessitent au minimum des tests électriques de parties du circuit en cours de fabrication ou d'assemblage pour évaluer la correction nécessaire.

Dans le cas du filtre mentionné précédemment, en plus de variations des valeurs de capacités, les dispersions de fabrication induisent également des variations de la fréquence de fonctionnement. Des éléments d'ajustement de la fréquence de fonctionnement sont donc habituellement ajoutés au circuit. Ceci peut être fait en modifiant la fréquence de l'oscillateur définissant la fréquence de fonctionnement du circuit.

En poussant cette idée plus loin, il a même été proposé d'exploiter l'accordabilité en fréquence d'un convertisseur analogique/numérique à bande passante pour inclure l'opération de sélection de canal au sein du convertisseur. Là où un filtre de sélection de canal, caractérisé par une bande passante étroite mais un forte réjection, était placé avant le convertisseur analogique/numérique, il a été proposé de le supprimer et d'utiliser le résonateur du convertisseur comme élément filtrant comme décrit dans l'article de O. Shoaei et W. M. Snelgrove, Design and implementation of a tunable 40 MHz-70 MHz Gm-C bandpass ΔΣ modulator, IEEE Trans. on Circuits and Systems II: Analog and Digital Signal processing, vol. 44, p. 521 (1997), ce qui permet de simplifier l'architecture de réception.

De manière ultime, une conversion directe du signal radiofréquence a même été récemment envisagée, de manière à permettre une simplification encore plus grande des architectures, puisque l'on supprime dans ce cas également le mélangeur utilisé pour réaliser l'opération de diminution de la fréquence de la porteuse. Dans ce cas, c'est l'élément filtrant inséré dans la boucle du convertisseur analogique/numérique qui vient sélectionner le canal utile. Pour que cela soit réalisable, il est nécessaire de rendre le résonateur agile en fréquence.

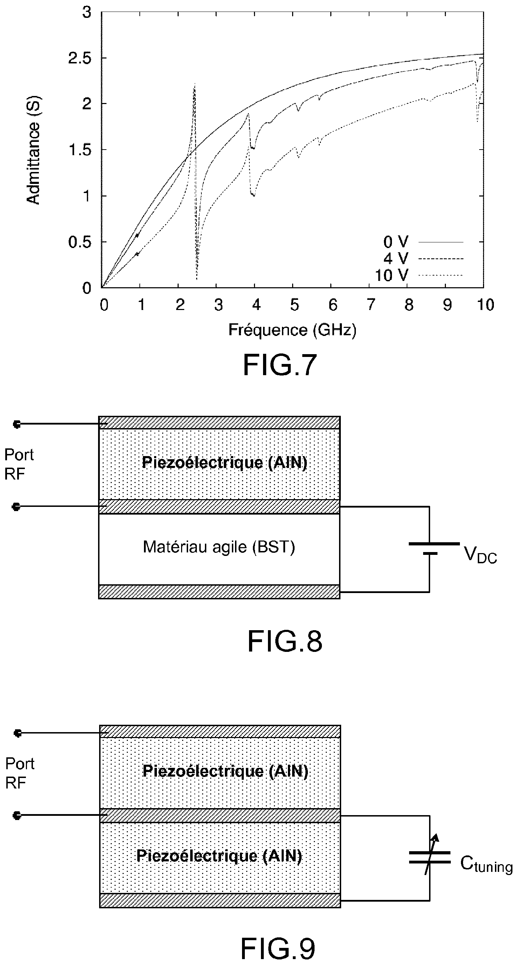

Un moyen de rendre les résonateurs agiles en fréquence consiste à utiliser des matériaux dont les propriétés élastiques sont variables en fonction d'un champ électrique continu que l'on peut appliquer en complément du signal radiofréquence, comme illustré en figure 6. Les meilleurs matériaux disponibles jusqu'à présent sont ceux de la famille cristalline pérovskite, et notamment le BaₓSr₁₋ₓTiO₃ (BST), qui en est le meilleur candidat comme l'ont décrit S. Gevorgian, A. Vorobiev et T. Lewin, DC-field and temperature dependent acoustic résonances in parallel-plate capacitors based on SrTiO3 and Ba0.25Sr0.75TiO3 films: experiment and modeling, J. Appl. Phys. 99, 124112 (2006), permettant d'obtenir une variation relative de fréquence de résonance approchant les 6 %. Ce type de matériau souffre cependant d'un défaut majeur : les propriétés diélectriques de ce matériau dépendent également du champ électrique statique appliqué, ce qui provoque des variations de la capacité statique du résonateur concomitantes avec des variations de fréquence, comme illustré sur la figure 7.

Il est également connu de la demande de brevet de Klee : US 2002/021192, un résonateur accordable en fréquence avec une structure ne comportant qu'une seule couche active à base de matériau ferroélectrique. La demande de brevet US 2011/316649 A1 décrit quant à elle un filtre à réactance du type en échelle ou en treillis, comprenant un condensateur monté en parallèle avec au moins l'un des résonateurs en série du filtre à réactance.

Ceci rend problématique la compensation de la capacité statique du résonateur, puisqu'il faut pouvoir assurer à tout moment que les capacités du circuit de compensation de la figure 4 soient parfaitement appariées aux capacités statiques des résonateurs. Par rapport à la première problématique d'appariement de valeurs de capacités malgré des dispersions de fabrication, on ajoute dans ce cas précis une difficulté supplémentaire du fait de la variabilité en cours de fonctionnement des éléments considérés. Il faut donc pouvoir s'assurer que les composants à apparier présentent les mêmes dispersions initiales, mais également les mêmes variations en cours de fonctionnement. A l'heure actuelle, aucune solution à ce problème n'a été apportée.

En l'absence de solution à ce second problème, d'autres types de résonateurs accordables, ne présentant pas la variation de la capacité statique en fonction de l'excursion en fréquence, ont été proposés dans la littérature. Il a par exemple été proposé dans la demande de brevet des auteurs R. Sinha, L.R. Carley, D.Y. Kim, *Devices having a tunable acoustic path length and methods for making the same,* brevet US 2009/02895256 A1, de réaliser un résonateur composite, utilisant une couche piézoélectrique (par exemple d'AIN) connectée au circuit radiofréquence (et donc ne présentant pas de variations d'impédances), accolée à un matériau agile, tel le BST, relié à un générateur de tension continue destiné à modifier ses propriétés élastiques effectives. Une telle structure est représentée sur la figure 8. L'agilité n'étant obtenue qu'indirectement par une modification de la vitesse de propagation des ondes acoustiques (de l'ordre de 1 % pour le BST) dans une partie seulement du résonateur, les variations de la fréquence de résonance escomptables restent donc relativement modestes.

Une possibilité d'atteindre une plus grande variation de fréquence consiste à exploiter un autre mécanisme physique : une modification des conditions aux limites électriques appliquées à un film piézoélectrique (par connexion du film à une capacité variable extérieure par exemple) permet de viser des variations relatives de fréquences proportionnelles au coefficient de couplage électromécanique des ondes exploitées comme décrit dans l'article : A.A. Frederick, H.H. Hu et W.W. Clark, Frequency tuning of film bulk acoustic resonators, Proc. of SPIE, vol. 6172, p. 617203 (2006).

Pour un résonateur composite AlN/AlN, ceci permet au mieux de viser des variations relatives de fréquence de 3 %, c'est-à-dire deux fois moindres que les résonateurs BST. L'utilisation de matériaux possédant des propriétés piézoélectriques bien supérieures à l'AlN, tels que par exemple le LiNbO₃ ou le KNbO₃ permettrait en théorie d'espérer des variations relatives de fréquence de 25 %, mais à ce jour ces matériaux restent difficilement intégrables dans des résonateurs composites (P. Murait, J. Antifakos, M. Cantoni, R. Lanz et F. Martin, Is there a better material for thin film BAW applications than AlN ?, 2005 Ultrasonics Symposium Proceedings, p. 315 (2005))

Quel que soit le mécanisme physique employé dans les deux derniers types de résonateurs variables, même si ces structures présentent une valeur de capacité statique constante quelle que soit l'excursion en fréquence, il n'en demeure pas moins qu'il est nécessaire, en vue de l'utilisation de ces résonateurs dans le filtre d'un convertisseur analogique-numérique filtrant, d'utiliser des capacités de compensation dont la valeur est rigoureusement égale à la capacité statique du résonateur, ce qui conduit au premier problème énoncé.

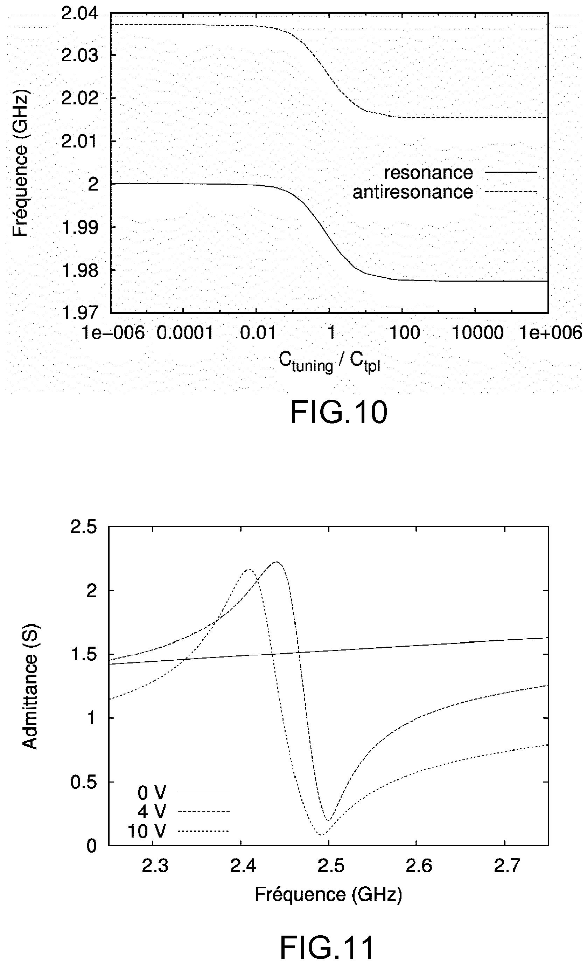

Pour les structures composites utilisant deux couches piézoélectriques telles que représentées en figure 9, le pilotage de la fréquence se fait par le biais d'une capacité variable dont la valeur doit être ajustée relativement par rapport à la capacité de la couche d'ajustement (la couche piézoélectrique inférieure sur la figure 9), comme l'illustre la figure 10. Un des moyens de piloter précisément ce type de composants consiste à réaliser une banque de capacités commutées de manière à basculer la sortie de la couche piézoélectrique inférieure vers une capacité valant *xCₜₚₗ,* où x est un facteur pouvant être supérieur ou inférieur à 1 (par exemple, x compris entre 1/100 et 100) et *Cₜₚₗ* la capacité formée par la couche d'accord en fréquence. Pour que cela soit possible sans que des dispersions technologiques ou des variations environnementales n'introduisent un décalage entre les valeurs nécessaires au pilotage du résonateur et celles fournies par la banque de capacité, il est nécessaire également de venir apparier les capacités de la banque à celles de la couche d'accord du résonateur. Ce type de composant génère donc une troisième problématique : être capable de fournir des capacités restant toujours proportionnelles à une capacité de référence, quelles que soient les dérives de fabrications ou bien les dérives sur les valeurs de capacités rencontrées en cours de fonctionnement du circuit.

Dans ce contexte, la présente invention a pour objet une solution consistant à co-intégrer des capacités avec des résonateurs acoustiques en les formant à partir du même film ferroélectrique ou piézoélectrique que le résonateur ou sa partie d'accord. Il s'agit en effet du moyen le plus direct de résoudre les trois problèmes mentionnés ci-dessus :
- en réalisant la capacité en utilisant la même couche ferroélectrique ou piézoélectrique que celle utilisée pour former un des éléments du résonateurs, on s'assure que les dérives sur l'épaisseur du dépôt se répercutent de manière identique sur les deux composants et induisent ainsi des variations de capacités identiques (si les géométries des électrodes sont identiques) ou proportionnelles (pour des géométries différentes) ;
- de même, toute variation de la permittivité diélectrique du matériau utilisé (provoquée par des variations de température, de contrainte ou de tension électrique) impacte à la fois la portion de résonateur considéré et la capacité, ce qui encore une fois se traduit par des variations identiques ou au moins proportionnelles des valeurs de capacités entre les deux éléments.

Ce concept simple se heurte cependant à un obstacle majeur : en réalisant un résonateur, on dimensionne l'empilement technologique de manière à assurer que le résonateur présente une résonance acoustique précisément à la fréquence de travail. Une capacité réalisée à partir de la même structure présente donc également ces résonances, et ne se comporte donc pas comme une simple capacité.

C'est pourquoi dans ce contexte, la présente invention repose plus précisément sur le fait de réaliser une capacité à partir du film ferroélectrique ou piézoélectrique à partir duquel est formé le résonateur, mais en apportant une modification locale à l'empilement de couches utilisées pour la réalisation du résonateur et de la capacité de compensation, et ce pour déplacer les fréquences des résonances de la capacité hors de la gamme de fréquences de travail en ajoutant localement (ou au contraire en supprimant localement) une ou plusieurs couches existantes par ailleurs dans l'empilement.

L'empilement de couches peut comprendre une couche de passivation, une couche de surcharge massique, une couche d'encapsulation, ou même une sur-métallisation. Ces éléments n'affectant pas les propriétés diélectriques du film, elles ne perturbent pas la valeur de la capacité, mais uniquement les résonances mécaniques.

Avantageusement, on peut également, affaiblir l'amplitude des résonances parasites ainsi formées en diminuant leur coefficient de qualité. Ceci peut être effectué en supprimant l'isolation acoustique intercalée entre le résonateur et le substrat (formation d'une membrane ou d'un miroir de Bragg), ou en ajoutant une surcharge massique réalisée à partir d'un matériau de très mauvaise qualité acoustique.

Généralement, opérer de cette manière se heurte au préjugé selon lequel la capacité ne se comporte pas comme une simple capacité, mais comme un circuit approximé comme une capacité mise en parallèle avec un certain nombre de branches L-C série, chacune de ces branches correspondant à une résonance acoustique. Des concepteurs peuvent donc craindre que la présence d'inductances dans ce schéma équivalent dénature le fonctionnement du circuit par rapport à l'utilisation d'une capacité. Néanmoins, la description détaillée de la présente demande ci-après met en exergue qu'il n'en est rien, et notamment dans le cas d'un circuit de compensation de la capacité statique d'un résonateur.

Ainsi selon la présente invention, en réalisant des capacités d'appariement à partir des mêmes films ferroélectriques ou piézoélectriques que des résonateurs, et en utilisant les mêmes géométries, on s'assure ainsi que les résonateurs et les capacités présentent les mêmes valeurs de capacités quelles que soient les dérives technologiques (dispersions d'épaisseurs d'une plaque à l'autre, ou sur une même plaque), ou quelques soient les conditions d'utilisation (température de fonctionnement, tension de polarisation, ...) des composants. Ceci est tout particulièrement appréciable dans un circuit de compensation d'une capacité statique, puisque cela permet de s'assurer qu'un filtre comme celui représenté sur la figure 4 assure toujours la compensation.

Plus généralement, ce principe peut être appliqué à tout circuit pour lequel on désire réaliser des capacités présentant des variations identiques à celles de la capacité de résonateurs électromécaniques co-intégrés.

Ainsi et plus précisément, la présente invention a pour objet une structure acoustique telle que définie par la revendication indépendante 1. Des variantes de l'invention sont proposées par les revendications dépendantes.

L'invention sera mieux comprise et d'autres avantages apparaîtront à la lecture de description qui va suive donnée à titre non limitatif et grâce aux figures annexées parmi lesquelles :
- la figure 1 illustre le schéma d'un système de réception utilisant un convertisseur analogique-numérique à bande passante, et incluant un résonateur sur le circuit ;
- la figure 2 illustre le schéma équivalent à un résonateur électromécanique ou acoustique de Butterwoorth-Van Dyke ;
- la figure 3 illustre la phase de l'admittance d'un résonateur électromécanique ou acoustique ;
- la figure 4 illustre le schéma d'un filtre obtenu par compensation de la capacité statique d'un résonateur acoustique ;
- la figure 5 illustre la fonction de transfert d'un résonateur acoustique dont la capacité statique a été compensée ;
- la figure 6 illustre le principe d'un résonateur agile en fréquence utilisant un film de BST ;
- la figure 7 illustre l'évolution de la réponse électrique d'un résonateur BST en fonction de la tension statique appliquée ;
- la figure 8 illustre un résonateur composite AlN/BST piloté par une tension continue ;
- la figure 9 illustre un résonateur composite AlN/AlN piloté par une capacité variable ;
- la figure 10 illustre les variations de fréquence d'un résonateur composite en fonction de la valeur de capacité d'ajustement ;
- la figure 11 illustre la réponse électrique d'un résonateur ferroélectrique en fonction de la tension de polarisation appliquée ;
- la figure 12 illustre la réponse électrique de la capacité obtenue en supprimant le miroir de Bragg et la couche de passivation ;
- la figure 13 illustre la réponse électrique obtenue en supprimant le miroir de Bragg et en plaçant des renforts métalliques directement sur la capacité ;
- les figures 14a et 14b illustrent la réponse électrique du circuit de compensation de la capacité statique du résonateur utilisant un second exemple de capacité ;
- les figures 15a à 15k illustrent les différentes étapes de réalisation d'un exemple illustratif de structure acoustique ne faisant pas partie de l'invention ;
- les figures 16a et 16b illustrent des exemples de connexion possibles du précédent exemple de structure représenté en figure 16k;
- les figures 17a à 17f illustrent les différentes étapes de réalisation d'un premier exemple de structure acoustique de l'invention ;
- la figure 18 illustre une vue de dessus d'une structure acoustique comprenant trois capacités cointégrées dans le cadre d'un exemple illustratif de structure acoustique ne faisant pas partie de l'invention comprenant un circuit de compensation de la capacité statique d'un résonateur à ondes de Lamb ;
- la figure 19 illustre une vue en coupe d'exemple de structure illustrée en figure 18 ;
- la figure 20 illustre un second exemple de structure acoustique de l'invention.

### Exemple de structure acoustique selon l'invention :

Un résonateur agile en fréquence est réalisé à partir d'un film de BST inséré entre une électrode inférieure de platine et une électrode supérieure de ruthénium, et recouvert d'une couche de passivation de silice.

Afin d'isoler ce résonateur du substrat, la structure comporte un miroir de Bragg à base d'une alternance de couches de tungstène et de silice W/SiO₂ composé de 5 couches, et dimensionné selon la méthode proposée dans la demande de brevet de S. Marksteiner, G. Fattinger, R. Aigner et J. Kaitila, *Acoustic reflector for a BAW resonator,* brevet US 2004/0140869 A1.

L'épaisseur de la couche de BST est fixée à 240 nm pour des raisons technologiques tandis que les épaisseurs de la couche de passivation et des électrodes sont déterminées pour fournir une résonance aux fréquences désirées, et pour réaliser des capacités d'accord, tel qu'exposé ci-après. Les épaisseurs des couches composant ce résonateur sont rapportées dans la seconde colonne du Tableau 1 ci-dessous :

**Tableau 1**

| | Résonateur | Capacité (exemple1) | Capacité (exemple 2) |
|---|---|---|---|
| Renforts de métallisation | - | - | 1 µm |
| Passivation (SiO₂) | 420 nm | - | |
| Electrode supérieure (Pt) | 220nm | | |
| Film ferroélectrique (BST) | 240 nm | | |
| Electrode inférieure (Pt) | 200 nm | | |
| Miroir 5 (SIO₂) | 600 nm | 2450 nm | |
| Miroir 4 (W) | 550 nm | - | |
| Miroir 3 (SiO₂) | 600 nm | - | |
| Miroir 2 (W) | 600 nm | - | |
| Miroir 1 (SiO₂) | 100 nm | - | |
| Substrat (Si) | 725 nm | | |

Cet empilement permet l'obtention d'un résonateur fonctionnant par exemple dans la bande ISM, et présentant une agilité en fréquence suffisante pour lui permettre de couvrir les canaux de la bande situés entre 2.412 et 2.472 GHz. Sa réponse électrique est représentée sur les figures 7 et 11, pour différentes valeurs de tension de polarisation statique.

On peut noter une variation de la fréquence de résonance sur la plage visée pour différentes valeurs de tension, ainsi qu'une variation de capacité statique quasiment d'un facteur 2. L'utilisation d'une capacité externe, difficile à apparier exactement, ne pourrait suivre de telles variations en fonction de la tension appliquée.

Conformément à la présente invention, il a été réalisé une capacité à partir du même film ferroélectrique de BST et des métallisations pour définir les électrodes. En vue de ne pas subir les résonances parasites de la capacité aux fréquences de travail, la couche de passivation a été supprimée au niveau de la capacité.

Pour atténuer les résonances restantes, la structure de miroir de Bragg n'est pas conservée sous les capacités : ceci est obtenu en ne conservant pas les couches de W à cet endroit.

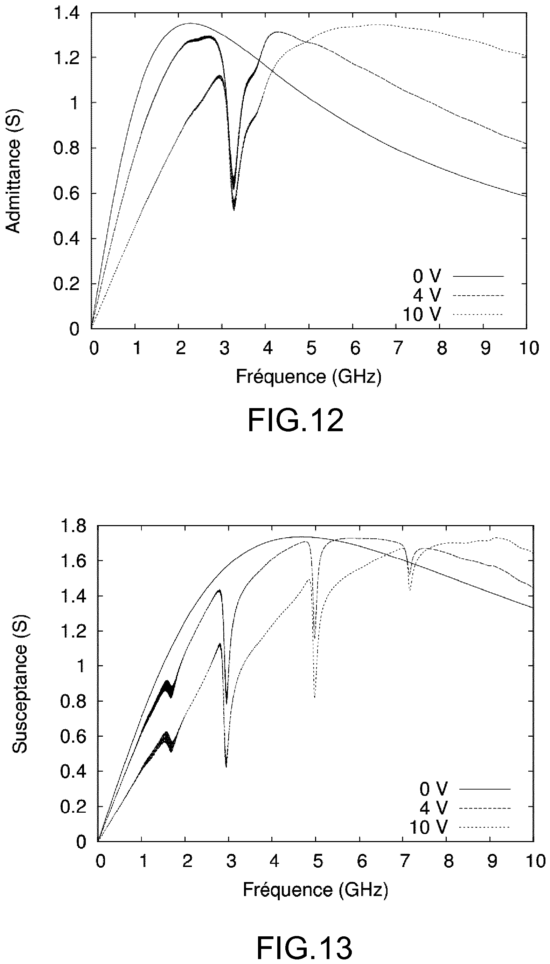

L'empilement des capacités ainsi formées est présenté dans la troisième colonne du Tableau 1, et la réponse électrique des capacités est fournie sur la figure 12. Sur la courbe de susceptance (partie imaginaire de l'admittance), on retrouve la variation d'un facteur quasiment 2 de la capacité, en accord avec les variations de capacité statique du résonateur correspondant à la configuration de la colonne 2 du Tableau 1, pour les mêmes valeurs de tension.

La résonance acoustique à 2.45 GHz a cédé la place à une multitude de résonances plus faibles, car obtenues en pratique par des résonances des ondes acoustiques se propageant dans le substrat. Une résonance plus marquée apparaît aux alentours de 3 GHz, au-delà de la fréquence de travail, correspondant à la résonance des ondes confinées dans le résonateur BST. En réduisant les épaisseurs des électrodes (et en épaississant en retour l'épaisseur de passivation pour retrouver les fréquences de résonance cibles) on peut augmenter dans une certaine mesure la fréquence de cette résonance parasite si besoin.

L'exemple précédent a présenté une méthode d'élaboration d'une capacité en venant augmenter la fréquence de résonance des ondes générées par le film ferroélectrique dans les capacités. Il est à l'inverse possible d'abaisser cette fréquence. Ceci peut par exemple être obtenu en ajoutant une charge massique à l'empilement. Afin de ne pas introduire de couche supplémentaire comme cela est réalisé classiquement pour des résonateurs à ondes de volume comme décrit dans l'article de A.A. Shirakawa, J.M. Pham, P. Jarry, E. Kerhervé, Design of FBAR filters at high frequency bands, International Journal of RF and Microwave Computer-Aided Engineering, vol. 17, p. 115 (2007), on utilise ici les renforts métalliques ajoutés pour optimiser les contacts électriques, c'est-à-dire une importante épaisseur de métal (1 µm).

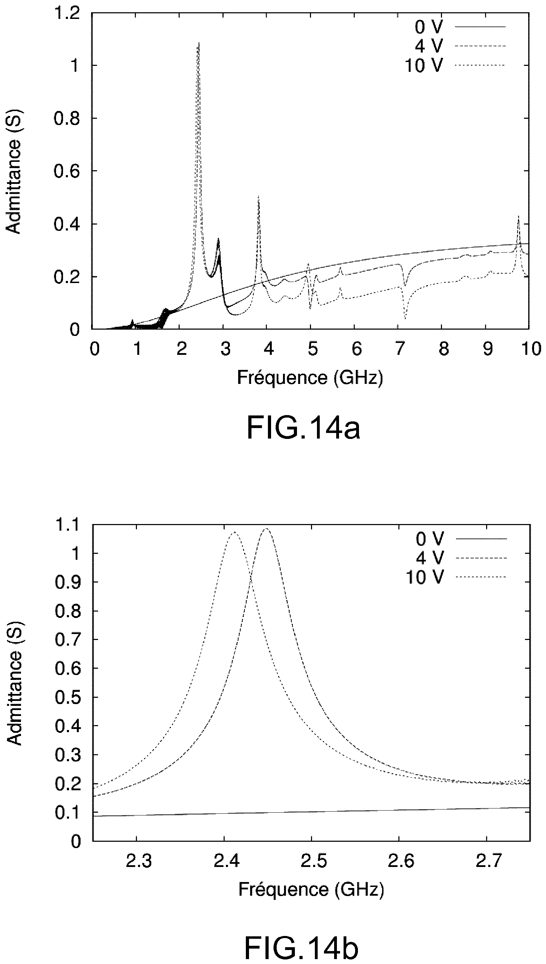

Les figures 14a et 14b illustrent la réponse électrique du circuit de compensation de la capacité statique du résonateur utilisant cette deuxième version de capacités. Comme le montrent ces figures, la résonance de la couche de BST (accompagnée de résonances provoquées par les réflexions des ondes sur la face arrière du silicium) est déplacée à une fréquence de 1.7 GHz, tandis que des résonances parasites supplémentaires dans la couche métallique font leur apparition à 3, 5 et 7 GHz. On remarque que la valeur de la capacité n'est toutefois toujours pas impactée.

Les résonances parasites des capacités font apparaître des pics d'admittance à 1.5, 3 et 4 GHz, mais sans que ceux-ci ne soient critiques pour le fonctionnement du filtre. La réponse en bande étroite, comme illustré sur la figure 14b, montre de plus que la résonance du filtre est particulièrement lisse, puisque les capacités ne présentent plus de résonances liées aux réflexions sur la face arrière du substrat aux fréquences de travail.

### Exemple d'application ne faisant pas partie de l'invention : utilisation dans un circuit de compensation de la capacité statique d'un résonateur ferroélectrique

Cet exemple de réalisation est relatif au premier exemple de filtre décrit précédemment : on réalise un résonateur accordable en fréquence à partir d'un film de BST déposé sur un miroir de Bragg. Les capacités de compensation sont quant à elles réalisées en supprimant localement la couche de passivation.

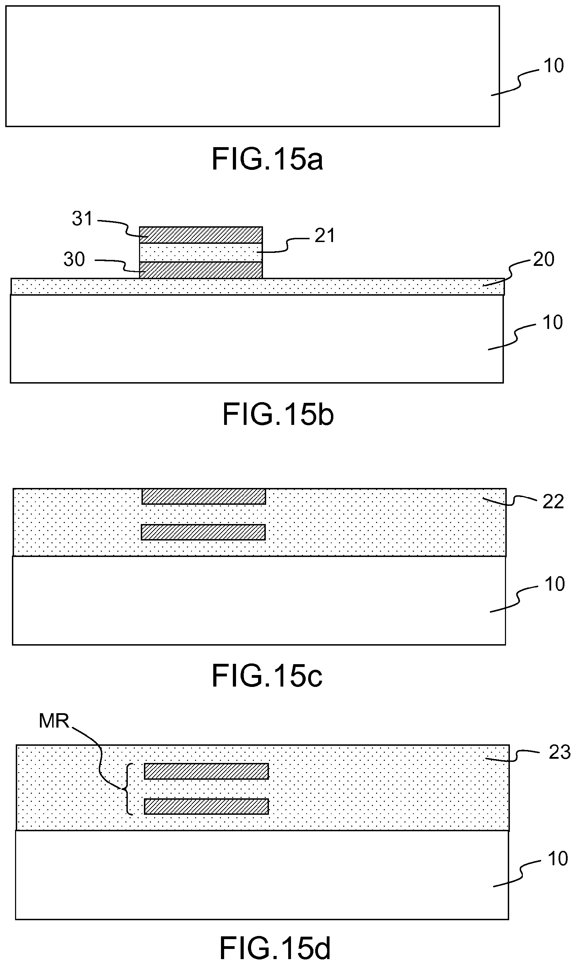

Selon une première étape illustrée en figure 15a, on procède au nettoyage d'un substrat silicium haute résistivité 10.

Selon une seconde étape illustrée en figure 15b, on procède à la réalisation de l'empilement suivant afin de réaliser une structure de Miroir de Bragg, sur le substrat 10 :
- une couche 20 de SiO₂ de 100nm par dépôt PECVD
- un assemblage 30 comportant :
   ∘ une couche de TiN de 10 nm
   ∘ une couche de W de 600 nm :
- une couche 21 de SiO₂ nm par dépôt PECVD
- un assemblage 31 comportant :
   ∘ une couche de TiN de 10 nm ;
   ∘ une couche de W de 600 nm

Puis on utilise un procédé de lithographie, gravure sèche, des couches W/SiO₂/W et retrait de résine afin de définir des motifs métalliques définissant les couches des miroirs de Bragg sous les résonateurs.

Selon une troisième étape illustrée en figure 15c, on réalise le dépôt d'une couche 22 de SiO₂ de 2300 nm. Puis, on utilise un procédé de photolithographie, gravure partielle (1800 nm) d'un contre-masque, retrait de résine et enfin planarisation du SiO₂ pour venir affleurer au niveau des motifs de tungstène.

Selon une quatrième étape illustrée en figure 15d, on procède au dépôt d'une couche 23 de SiO₂ de 640 nm d'épaisseur correspondant à la couche supérieure de miroir de Bragg MR.

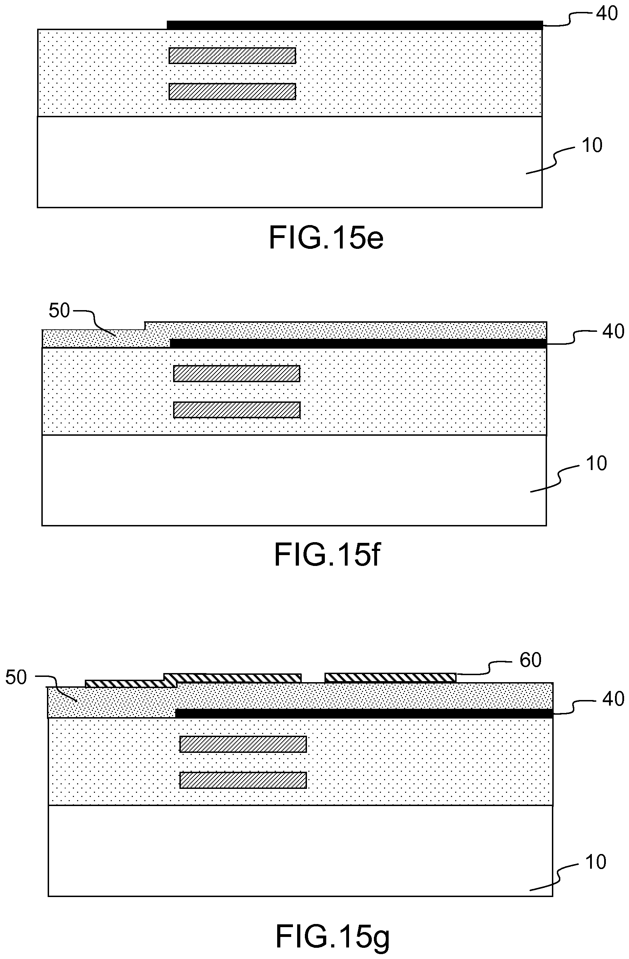

Selon une cinquième étape illustrée en figure 15e, on procède au dépôt d'une couche de croissance d'accrochage de Ti (40 nm) par pulvérisation, oxydation, puis dépôt d'une couche de Pt (200 nm) par pulvérisation. Par photolithographie, fluage de la résine dans une étuve, gravure IBE (*Ion Beam Etching*), puis retrait de résine, on définit ainsi une métallisation inférieure 40.

Selon une sixième étape illustrée en figure 15f, on procède à la réalisation d'une couche 50 de BST par sol-gel et enchainement de 8 étapes d'étalement / séchage sur plaque chauffante / calcination pour atteindre une épaisseur de couche de BST de 240 nm d'épaisseur.

Selon une septième étape illustrée en figure 15g, on procède au dépôt d'une couche 60 de Ru (220 nm) par pulvérisation. Par photolithographie, gravure humide du Ru, retrait de résine, on obtient des métallisations supérieures.

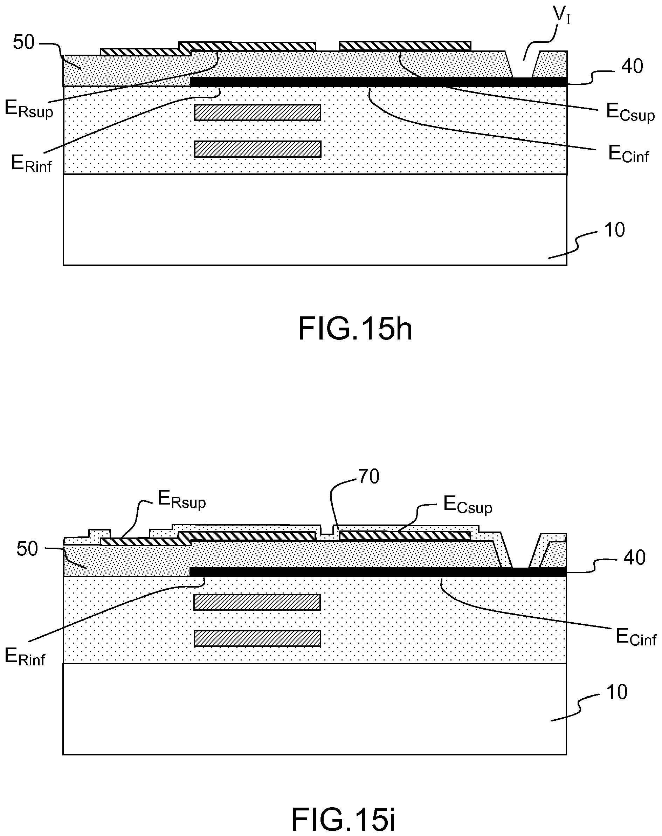

Selon une huitième étape illustrée en figure 15h, on réalise par photolithographie, gravure humide du BST (HF / HCl) une ouverture de contacts V_{I}, vers l'électrode inférieure, on procède également au retrait de résine. Sur cette figure, ont été référencées les électrodes E_{Rsup} et E_{Rinf} du résonateur ainsi que celles de la capacité de compensation : E_{Ccsup} et E_{Ccinf}.

Selon une neuvième étape illustrée en figure 15i, on réalise un dépôt d'une couche 70 de passivation pouvant être en SiO₂ par PECVD. On procède également par photolithographie et gravure humide (HF) à la réalisation d'ouverture de cette couche de passivation au niveau des via pour ouvrir des contacts vers les électrodes inférieures et supérieures, on procède alors au retrait de résine.

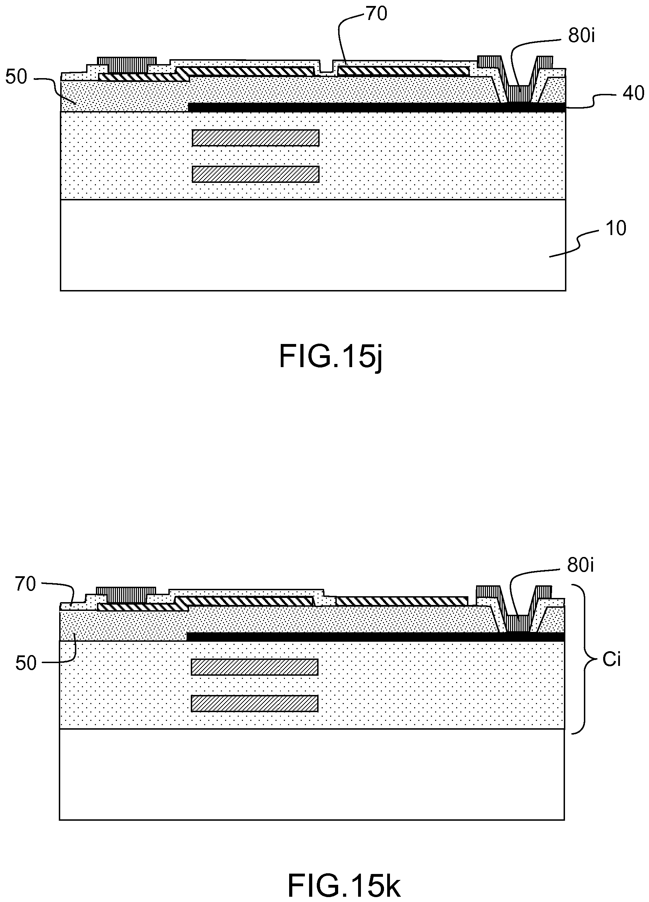

Selon une dixième étape illustrée en figure 15j, on procède au dépôt de deux couches de Cr/Au par pulvérisation. On définit des contacts électriques 80i par photolithographie, gravure humide, puis retrait de résine.

Selon une onzième étape illustrée en figure 15k, on dégage par photolithographie, gravure sèche de l'oxyde de passivation au niveau de la couche 70, puis par retrait de résine on dégage des ouvertures au niveau des capacités dans cette couche 70.

La figure 15k met ainsi en évidence un exemple de structure acoustique selon le présent exemple:
- un empilement de couches Ci au dessus d'un substrat de silicium comportant l'ensemble des couches suivantes :
   ∘ une couche épaisse de SiO₂ comprenant localement une structure de miroir de Bragg ;
   ∘ une couche de métallisation inférieure permettant de définir les électrodes inférieures du résonateur et de la capacité co-intégrée ;
   ∘ une couche de matériau ferroélectrique de BST correspondant à la couche active ;
   ∘ une couche de métallisation supérieure dans laquelle sont définies les électrodes supérieures du résonateur et de la capacité co-intégrée ;
   ∘ une couche supérieure de passivation localement supprimée au niveau de la capacité pour modifier les résonances acoustiques sans modifier la valeur de la capacité co-intégrée lorsque l'on fait varier en fréquence le résonateur.

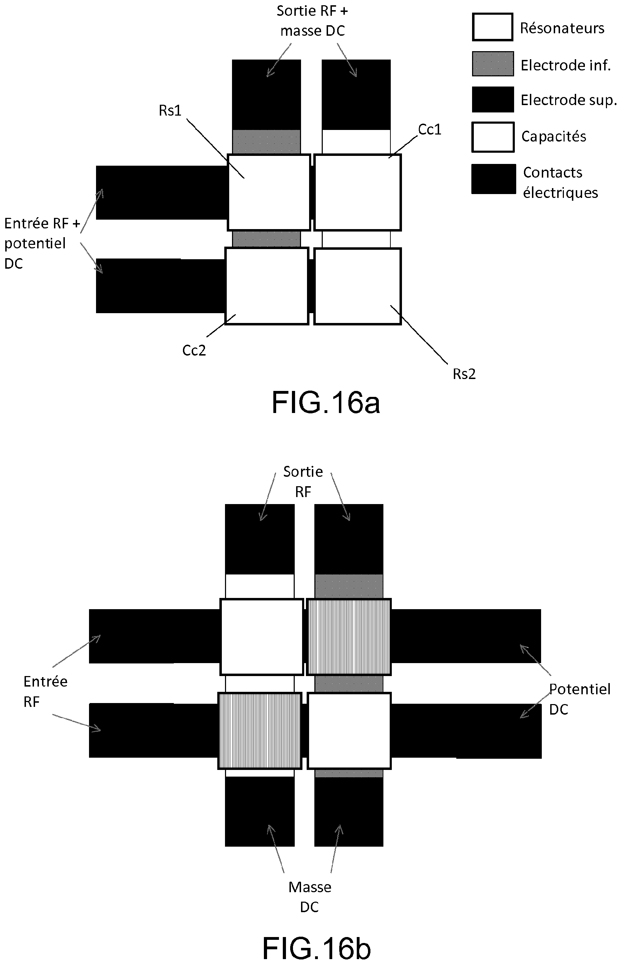

Les figures 16a et 16b illustrent des exemples de dessins de masques permettant de réaliser des résonateurs dont la capacité statique est compensée dans un montage en ponts tel que celui représenté en figure 4, et comprenant deux résonateurs Rs₁ et Rs₂ ainsi couplés électriquement aux deux capacités de compensation C_{c1} et C_{c2}.

En raison de la topologie en treillis de la structure, les entrées électriques sont toutes situées sur un même niveau de métallisation, ici les électrodes supérieures, tandis que les sorties électriques sont localisées sur un autre niveau. La masse n'est pas représentée, cette dernière étant virtuelle pour un circuit différentiel. Dans ce circuit, les résonateurs et les capacités sont polarisés avec les mêmes potentiels si l'on applique une différence de potentiel statique entre les électrodes d'entrée et de sortie (même potentiel pour les deux électrodes d'entrée et même potentiel pour les deux électrodes de sortie). Cette différence de potentiel peut être directement superposée aux signaux RF. La figure 16a montre une configuration dans laquelle, les connections RF et les commandes statiques des capacités ne sont pas distinctes. La figure 16b montre une configuration dans laquelle, les connections RF et les commandes statiques des capacités sont distinctes.

Une variante du précédent exemple de structure acoustique ne faisant pas partie de l'invention peut être obtenue en substituant l'opération de retrait local de la couche de passivation, par la réalisation de sur-épaisseurs de la couche de métallisation 60 (illustrée notamment en figure 15h) au niveau de la capacité de compensation.

### Premier exemple d'application selon l'invention : utilisation dans un circuit de compensation de la capacité statique d'un résonateur composite piézoélectrique/ferroélectrique

Selon la présente invention, Il est également possible d'utiliser des résonateurs dits « composites », comme ceux de la figure 8. Dans ce cas, on cherche à compenser la capacité statique présentée par la couche piézoélectrique d'AlN reliée au circuit RF, la couche de BST ne servant qu'à assurer la variation de fréquence. Dans cette configuration, la réalisation de l'invention peut être réalisée de plusieurs manières, en fonction de la conception du résonateur, et en particulier des épaisseurs de la couche d'accordabilité :
- si la couche d'accordabilité possède une épaisseur proche d'un quart d'onde, elle ne présente que peu d'influence sur la fréquence du résonateur complet. Dans ce cas, le moyen le plus sûr de décaler les fréquences de résonance consiste à venir ajouter une surface de métal, ou à effectuer une ouverture de passivation comme dans les deux exemples de réalisation précédents ;
- si par contre la couche d'accordabilité diffère significativement d'un quart d'onde, son retrait local entraîne une forte variation de fréquence qui peut être avantageusement utilisée en vue de la présente invention.

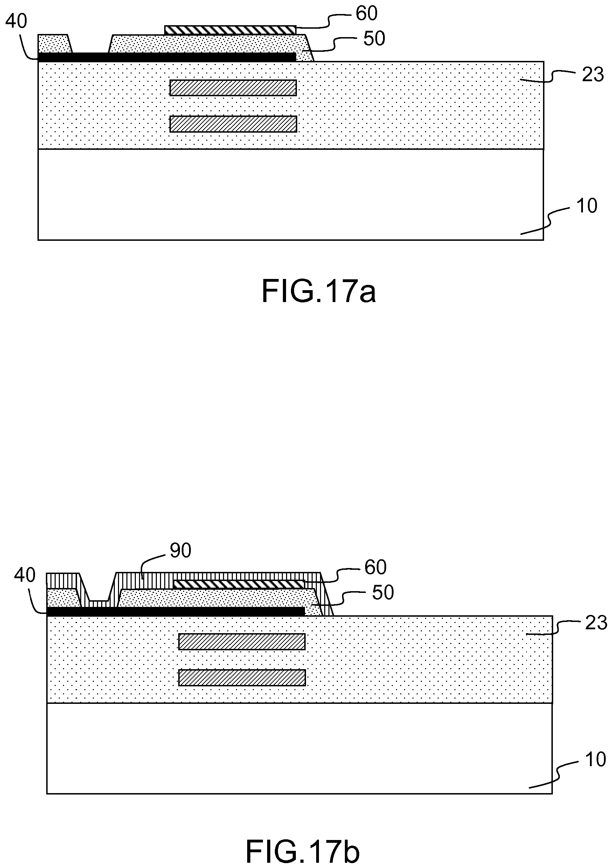

L'ensemble des étapes de procédé décrites en figure 17a a à 17f illustrent un procédé de fabrication permettant une telle structure acoustique.

Les étapes de procédé sont communes à celles du premier exemple d'utilisation de structure acoustique de l'invention, jusqu'à l'étape de définition des électrodes supérieures. On a donc constitué à la surface de silicium 10, l'empilement de couches : 23, 40, 50 et 60. La seule différence est qu'au niveau de la conception, il est prévu de larges ouvertures de la couche 50 de BST afin de dégager de la surface pour la réalisation des capacités, comme représenté en figure 17a.

Selon une étape ultérieure, illustrée en figure 17b, on procède au dépôt d'une couche d'isolation électrique 90 en SiO₂ par PECVD, de façon à encapsuler l'empilement du matériau ferroélectrique de BST inséré entre une électrode inférieure et une électrode supérieure.

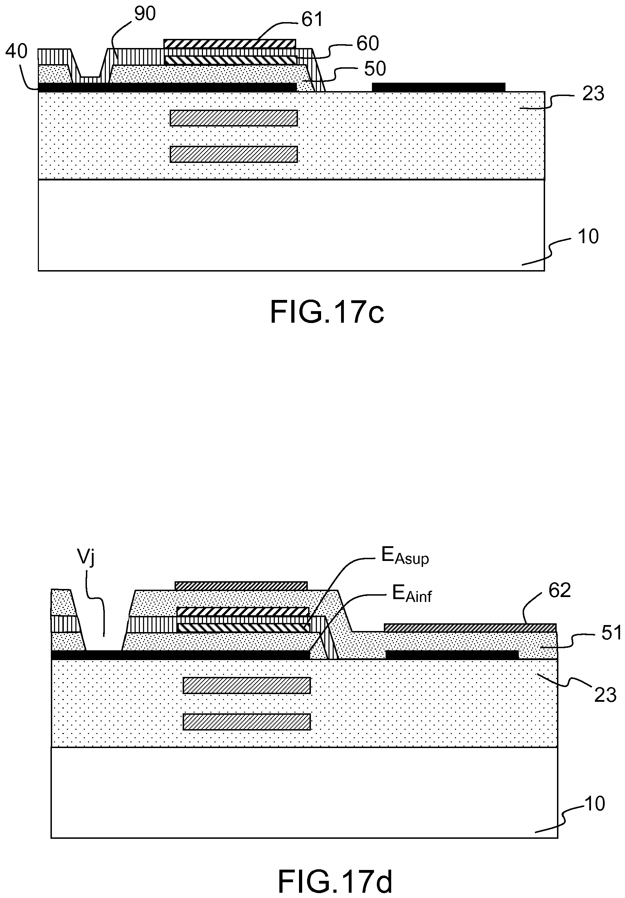

Selon une étape ultérieure, illustrée en figure 17c, on procède au dépôt d'une couche de métallisation 61 en Molybdène qui servira d'électrode inférieure à la couche piézoélectrique, localisée par gravure sèche fluorée en présence d'un masque de résine.

Selon des étapes ultérieures, illustrées en figure 17d, on procède au dépôt de la couche active 51 de cette structure acoustique avec un matériau piézoélectrique d'AlN par pulvérisation cathodique réactive. On réalise ensuite le dépôt d'une couche supérieure 62 en Mo par pulvérisation. On définit alors des électrodes supérieures par photolithographie et gravure sèche fluorée. On réalise ensuite des ouvertures de contacts électriques Vj, à travers les couches diélectriques par photolithographie, gravure chimique de l'AlN dans un bain de H₃PO₄ chauffé à 80°C, puis gravure de la couche d'isolation électrique dans un bain d'acide fluorhydrique. Cette figure met en évidence les électrodes de la partie accordable en fréquence E_{Asup} et E_{Ainf}.

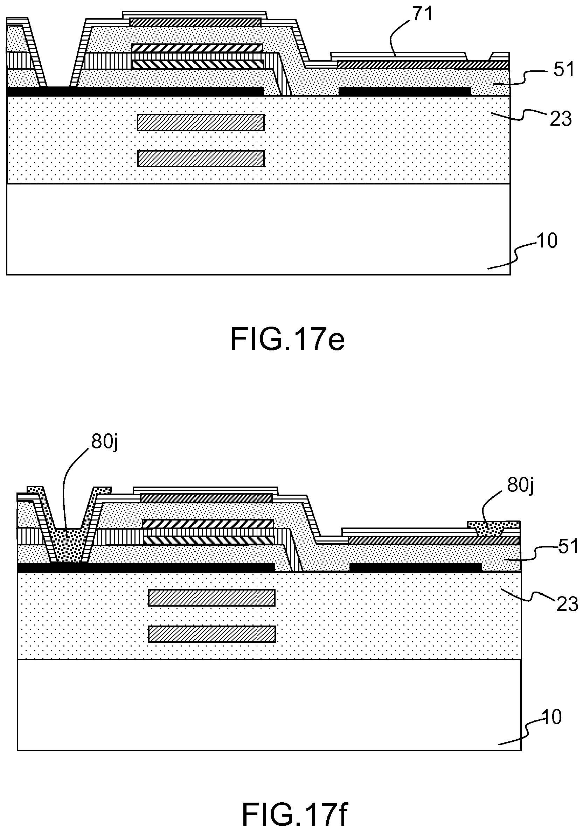

Selon des étapes ultérieures illustrées en figure 17e, on procède au dépôt d'une couche de passivation 71 en SiN par PECVD, à la réalisation d'ouvertures de cette passivation au niveau des contacts électriques par photolithographie et gravure sèche.

Enfin, lors d'une étape illustrée en figure 17f, on procède à la réalisation de contacts électriques 80j, en AlCu par pulvérisation et définition de ces contacts par photolithographie puis gravure humide.

### Autre exemple d'application ne faisant pas partie de l'invention : utilisation pour réaliser le circuit de compensation de la capacité statique d'un résonateur à ondes de Lamb à cavité étendue

Dans une précédente demande de brevet (A. Reinhardt, E. Defaÿ, F. Perruchot, *Dispositif électromécanique à ondes acoustiques comprenant une zone de transduction et une cavité étendue,* demande de brevet FR 1153633, avril 2011), le Demandeur a proposé d'utiliser une structure de résonateur à ondes de Lamb possédant une cavité de résonance étendue. Dans cette demande de brevet, les auteurs ont mentionné que cette cavité pouvait servir à rendre ce type de résonateur pilotable en fréquence si la cavité était métallisée à l'aide de peignes interdigités reliés à une capacité variable externe. Cette capacité doit présenter des valeurs égales ou proportionnelles à la capacité obtenue aux bornes des électrodes disposées sur la cavité d'accord en fréquence. Cette structure est en pratique l'analogue à celle du résonateur composite du second exemple, mais dans lequel laquelle la propagation des ondes acoustiques ne se fait plus verticalement, mais horizontalement dans le plan de la couche piézoélectrique.

Dans la mesure où le circuit de pilotage en fréquence d'un tel résonateur est idéalement une banque de capacités commutées (seul ce type de circuit permet de présenter des variations très grandes des valeurs de capacité), il devient nécessaire de réaliser un certain nombre de capacités individuelles dont la valeur est proportionnelle à la capacité présentée par les métallisations disposées sur la cavité du résonateur. Pour assurer une stricte proportionnalité quelles que soient les dispersions de fabrication ou les conditions de fonctionnement, l'application consiste à utiliser la couche piézoélectrique servant à réaliser le résonateur (c'est-à-dire son transducteur et la cavité) pour réaliser les capacités qui seront insérées dans la banque de capacités. Le coefficient de proportionnalité entre ces capacités et la capacité présentée par les électrodes de la cavité est alors fixé par les variations de géométrie des électrodes : variation du nombre de peignes servant à former la capacité, ou de la longueur des doigts, voire d'une combinaison des deux.

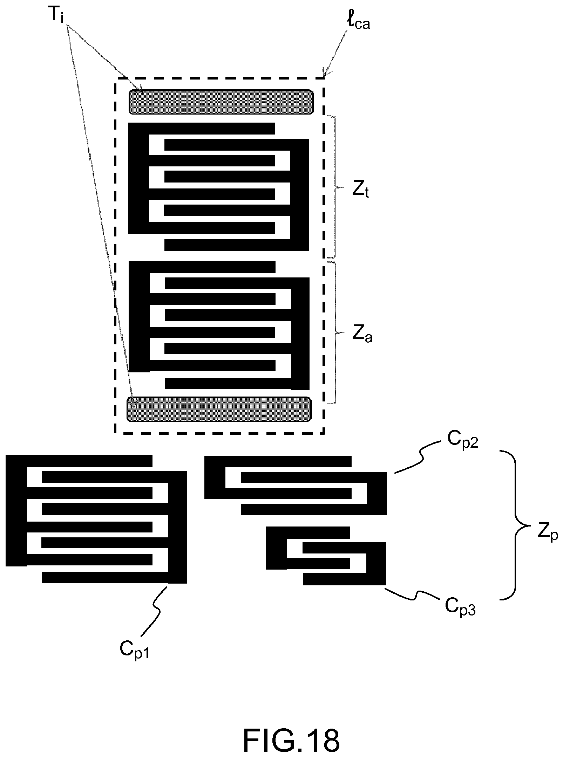

La figure 18 montre une vue de dessus d'une telle structure avec une zone Zt dédiée à la transduction, une zone Za dédiée à l'accord en fréquence et une zone Zp dédiée au pilotage en fréquence. Cette zone Zp dédiée au pilotage comprend dans cet exemple, par exemple trois capacités d'accord : Cp₁, Cp₂ et Cp₃ co-intégrées pouvant présenter des valeurs de capacités respectivement égale, moitié et quart de la valeur de capacité du réseau de peignes interdigités disposé sur la cavité

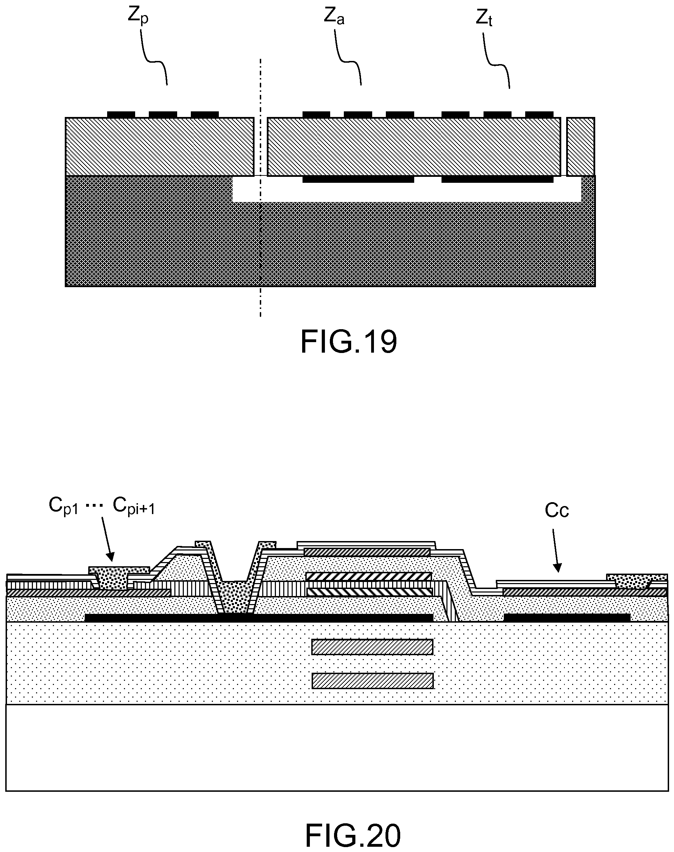

La figure 19 montre un schéma de coupe de cet exemple. La partie de droite correspond au résonateur et comprend deux groupes d'électrodes en forme de peignes interdigités : l'un servant de transducteur (zone de transduction Zt) et l'autre de cavité d'accord (zone d'accord Za). L'ensemble est isolé acoustiquement du substrat par le biais d'une cavité d'air formée sous le résonateur. La cavité résonante est définie par des tranchées verticales disposées de part et d'autre du composant et faisant office de réflecteurs. Une des capacités du circuit d'accord de pilotage Zp est représentée sur la partie gauche de la figure. Afin d'éviter l'obtention de résonances acoustiques parasites, les capacités sont disposées directement sur le substrat. Des couches supplémentaires peuvent être ajoutées pour décaler en fréquence d'éventuelles résonances persistantes.

### Second exemple d'application selon l'invention : utilisation pour compenser la capacité statique et réaliser le circuit de commande en fréquence d'un résonateur composite piézoélectrique/piézoélectrique

Une variante du premier exemple selon l'invention consiste à utiliser une couche piézoélectrique en vue d'obtenir des variations de fréquence, laquelle étant connectée à une banque de capacités.

Dans ces conditions, un mode de réalisation peut être similaire à celui détaillé pour le premier exemple selon l'invention. L'étape de dépôt de la couche ferroélectrique inférieure est alors remplacée par une étape de dépôt de nitrure d'aluminium (par exemple), par pulvérisation cathodique DC-pulsée réactive.

Les capacités de la banque de capacités sont alors réalisées dans la couche d'AlN inférieure, ce qui conduit à la structure illustrée en figure 18. Dans cette configuration, le rapport entre la surface du résonateur et celle des capacités, fixe la position en fréquence du résonateur composite, indépendamment des dispersions technologiques et des variations de température. La figure 20 met ainsi en évidence une série de capacités Cp1, Cpi+1 permettant d'ajuster la fréquence, ainsi que la capacité de compensation Cc.

## Revendications

1. Structure acoustique comprenant au moins un résonateur acoustique (Rs₁, Rs₂) présentant une zone dite de transduction et au moins une fréquence de résonance dans une bande de fréquences dites de fonctionnement et une capacité intégrée (Cc₁, Cc₂), **caractérisée en ce que** ladite structure acoustique comporte :
- un empilement de couches, comprenant au moins une première et une deuxième couches actives (50, 51) de matériau piézoélectrique ou de matériau ferroélectrique ;
- l'empilement de couches étant situé à la surface d'un substrat ;
- ledit résonateur étant accordable en fréquence et étant réalisé par un premier sous-ensemble de couches dudit empilement;
- le résonateur formé par le premier sous-ensemble de couches comportant :
o une première zone de transduction présentant ladite première couche active en matériau piézoélectrique et au moins deux électrodes et
o une deuxième zone dite d'accord en fréquence présentant ladite deuxième couche active en matériau piézoélectrique ou ferroélectrique et au moins deux électrodes ;
o ladite première zone étant formée au-dessus de ladite seconde zone et séparée de celle-ci par une couche d'isolation électrique ;
- ladite capacité intégrée étant réalisée par un deuxième sous-ensemble de couches comportant ladite première couche active et au moins deux électrodes (E_{Ccinf}, E_{Ccsup}) ;
- lesdits premier et second sous-ensembles de couches se distinguant par une modification de couches de manière à présenter des fréquences de résonances différentes ;
- ladite structure comprenant des moyens de pilotage en fréquence du résonateur reliés aux électrodes de la zone d'accord du résonateur et aux électrodes de la capacité intégrée ;
- la valeur de la capacité intégrée étant égale ou proportionnelle à la valeur de la capacité présentée par la zone d'accord du résonateur.

2. Structure acoustique selon la revendication 1, **caractérisée en ce que** ladite deuxième couche active est en matériau ferroélectrique.

3. Structure acoustique selon l'une des revendications 1 à 2, **caractérisée en ce que** l'électrode inférieure du résonateur (E_{Rinf}) et l'électrode inférieure de la capacité (E_{Cinf}) sont dans un même plan et l'électrode supérieure du résonateur (E_{Rsup}) et l'électrode supérieure de la capacité (E_{Csup}) sont dans un même plan.

4. Structure acoustique selon l'une des revendications 1 à 3, **caractérisée en ce que** le premier sous-ensemble de couches comporte des moyens de confinement des ondes acoustiques dans le résonateur.

5. Structure acoustique selon l'une des revendications 1 à 4, **caractérisée en ce qu'**elle comprend des moyens d'atténuation de résonances acoustiques parasites dans ledit second sous-ensemble de couches.

6. Structure acoustique selon la revendication 5, **caractérisée en ce que** les moyens d'atténuation comprennent dans le second sous- ensemble de couches, au moins une couche apte à absorber les ondes acoustiques.

7. Structure acoustique selon l'une des revendications 4 ou 5, **caractérisée en ce que** les moyens de confinement des ondes acoustiques dans le résonateur comportant une structure de miroir de Bragg, le second sous-ensemble de couches ne comporte pas cette structure pour réaliser une atténuation desdites résonances acoustiques parasites.

8. Structure acoustique selon la revendication 5, **caractérisée en ce que** le premier sous-ensemble de couches comprend une structure de membrane située sous la ou les couches actives dudit résonateur pour former une cavité résonante.

9. Structure acoustique selon l'une des revendications 1 à 8, **caractérisé en ce que** le matériau ferroélectrique est en BST.

10. Structure acoustique selon l'une des revendications 1 à 9, **caractérisé en ce que** le ou les matériau(x) piézoélectrique(s) de la première couche et/ou de la seconde couche est (sont) en AlN.

11. Structure acoustique selon l'une des revendications 1 à 10, **caractérisée en ce que** ladite structure comprend une couche supérieure de passivation, pouvant être en SiO₂.

12. Structure acoustique selon la revendication 11, **caractérisée en ce que** la modification de l'empilement dans le second sous-ensemble est réalisé dans ladite couche de passivation.

13. Structure acoustique selon l'une des revendications 1 à 11, **caractérisée en ce que** la couche d'isolation électrique est en SiO₂.

14. Structure acoustique selon l'une des revendications 1 à 13, **caractérisée en ce que** les électrodes supérieures de la couche active dans le premier sous-ensemble et dans le second sous-ensemble étant réalisées dans un même sous-ensemble métallique de couches, ladite modification de l'empilement dans ledit second sous-ensemble est réalisée par une sur-métallisation dudit sous-ensemble métallique.

15. Structure acoustique selon l'une des revendications 1 à 14, **caractérisée en ce qu'**elle comprend une structure de pont comportant deux résonateurs (Rs₁, Rs₂) couplés électriquement à deux capacités intégrées (C_{c1}, C_{c2})

## Patentansprüche

1. Akustische Struktur die mindestens einen akustischen Resonator (Rs₁, Rs₂) umfasst, der eine sogenannte Wandlungszone und mindestens eine Resonanzfrequenz in einem sogenannten Betriebsfrequenzband und einen integrierten Kondensator (Cc₁, Cc₂) aufweist, **dadurch gekennzeichnet, dass** die akustische Struktur Folgendes umfasst:
- einen Stapel von Schichten, der mindestens eine erste und eine zweite aktive Schicht (50, 51) aus piezoelektrischem Material oder ferroelektrischem Material umfasst;
- wobei sich der Stapel von Schichten auf der Oberfläche eines Substrats befindet;
- wobei der Resonator frequenzabstimmbar ist und durch eine erste Untergruppe von Schichten des Stapels produziert wird;
- wobei der durch die erste Untergruppe von Schichten gebildete Resonator Folgendes umfasst:
o eine erste Wandlungszone, die die erste aktive Schicht aus piezoelektrischem Material und mindestens zwei Elektroden aufweist, und
o eine zweite sogenannte Frequenzabstimmungszone, die die zweite aktive Schicht aus piezoelektrischem oder ferroelektrischem Material und mindestens zwei Elektroden aufweist;
o wobei die erste Zone über der zweiten Zone ausgebildet und von dieser durch eine elektrisch isolierende Schicht getrennt ist;
- wobei der integrierte Kondensator durch eine zweite Untergruppe von Schichten produziert wird, die die erste aktive Schicht und mindestens zwei Elektroden (E_{Ccinf}, E_{Ccsup}) umfasst;
- wobei sich die erste und zweite Untergruppe von Schichten durch eine Modifikation von Schichten unterscheiden, so dass sie unterschiedliche Resonanzfrequenzen aufweisen;
- wobei die Struktur Mittel zum Steuern der Frequenz des Resonators aufweist, die mit den Elektroden der Resonatorabstimmzone und mit den Elektroden des integrierten Kondensators verbunden sind;
- wobei der Wert des integrierten Kondensators gleich dem oder proportional zu dem Wert des Kondensators ist, der durch die Resonatorabstimmzone dargestellt ist.

2. Akustische Struktur nach Anspruch 1, **dadurch gekennzeichnet, dass** die zweite aktive Schicht aus ferroelektrischem Material ist.

3. Akustische Struktur nach einem der Ansprüche 1 bis 2, **dadurch gekennzeichnet, dass** die untere Elektrode des Resonators (E_{Rinf}) und die untere Elektrode des Kondensators (E_{Cinf}) auf einer selben Ebene liegen und die obere Elektrode des Resonators (E_{Rsup}) und die obere Elektrode des Kondensators (E_{Csup}) auf einer selben Ebene liegen.

4. Akustische Struktur nach einem der Ansprüche 1 bis 3, **dadurch gekennzeichnet, dass** die erste Untergruppe von Schichten Mittel zum Eingrenzen der akustischen Wellen im Resonator umfasst.

5. Akustische Struktur nach einem der Ansprüche 1 bis 4, **dadurch gekennzeichnet, dass** sie Mittel zur Dämpfung parasitärer akustischer Resonanzen in der zweiten Untergruppe von Schichten umfasst.

6. Akustische Struktur nach Anspruch 5, **dadurch gekennzeichnet, dass** die Dämpfungsmittel in der zweiten Untergruppe von Schichten mindestens eine Schicht umfassen, die die akustischen Wellen absorbieren kann.

7. Akustische Struktur nach einem der Ansprüche 4 oder 5, **dadurch gekennzeichnet, dass** die Mittel zum Eingrenzen der akustischen Wellen im Resonator eine Bragg-Spiegelstruktur umfassen, wobei die zweite Untergruppe von Schichten diese Struktur nicht umfasst, um eine Dämpfung der parasitären akustischen Resonanzen zu erzeugen.

8. Akustische Struktur nach Anspruch 5, **dadurch gekennzeichnet, dass** die erste Untergruppe von Schichten eine Membranstruktur umfasst, die unter der/den aktiven Schicht(en) des Resonators angeordnet ist, um einen Resonanzhohlraum zu bilden.

9. Akustische Struktur nach einem der Ansprüche 1 bis 8, **dadurch gekennzeichnet, dass** das ferroelektrische Material aus BST ist.

10. Akustische Struktur nach einem der Ansprüche 1 bis 9, **dadurch gekennzeichnet, dass** das (die) piezoelektrische(n) Material(ien) der ersten Schicht und/oder der zweiten Schicht aus AIN ist (sind).

11. Akustische Struktur nach einem der Ansprüche 1 bis 10, **dadurch gekennzeichnet, dass** die Struktur eine obere Passivierungsschicht umfasst, die aus SiO₂ sein kann.

12. Akustische Struktur nach Anspruch 11, **dadurch gekennzeichnet, dass** die Modifikation des Stapels in der zweiten Untergruppe in der Passivierungsschicht erfolgt.

13. Akustische Struktur nach einem der Ansprüche 1 bis 11, **dadurch gekennzeichnet, dass** die elektrische Isolierschicht aus SiO₂ ist.

14. Akustische Struktur nach einem der Ansprüche 1 bis 13, **dadurch gekennzeichnet, dass** die oberen Elektroden der aktiven Schicht in der ersten Untergruppe und in der zweiten Untergruppe in einer gleichen metallischen Untergruppe von Schichten produziert sind, wobei die Modifikation des Stapels in der zweiten Untergruppe durch eine Übermetallisierung der metallischen Untergruppe durchgeführt wird.

15. Akustische Struktur nach einem der Ansprüche 1 bis 14, **dadurch gekennzeichnet, dass** sie eine Brückenstruktur mit zwei Resonatoren (Rs₁, Rs₂) umfasst, die elektrisch mit zwei integrierten Kondensatoren (C_{c1}, C_{c2}) gekoppelt sind.

## Claims

1. Acoustic structure comprising at least one acoustic resonator (Rs₁, Rs₂) having a so-called transduction zone and at least one resonant frequency in a band of so-called operating frequencies and an integrated capacitor (Cc₁, Cc₂), **characterized in that** said acoustic structure comprises:
- a stack of layers, comprising at least a first and a second active layer (50, 51) of piezoelectric material or of ferroelectric material;
- wherein the stack of layers is situated on the surface of a substrate;
- said resonator being frequency tunable and being produced by a first subset of layers of the said stack;
- the resonator formed by the first subset of layers comprising:
o a first transduction zone having said first active layer of piezoelectric material and at least two electrodes and
o a second so-called frequency-tuning zone having said second active layer of piezoelectric material or ferroelectric material and at least two electrodes;
o said first zone being formed above said second zone and separated from it by an insulation layer;
- said integrated capacitor being produced by a second subset of layers comprising said active layer and at least two electrodes (E_{Ccinf}, E_{Ccsup});
- said first and second subsets of layers being distinguished by a modification of layers so as to have different resonant frequencies;
- said structure comprising means of frequency-driving of the resonator which are linked to the electrodes of the resonator tuning zone and to the electrodes of the integrated capacitor;
- the value of the integrated capacitor being equal or proportional to the value of the capacitor presented by the resonator tuning zone.

2. Acoustic structure according to claim 1, **characterized in that** said second active layer is made of ferroelectric material.

3. Acoustic structure according to one of claims 1 to 2, **characterized in that** the lower electrode of the resonator (E_{Rinf}) and the lower electrode of the capacitor (E_{Cinf}) are in a same plane and the upper electrode of the resonator (E_{Rsup}) and the upper electrode of the capacitor (E_{Csup}) are in a same plane.

4. Acoustic structure according to one of claims 1 to 3, **characterized in that** the first subset of layers comprises means for confining the acoustic waves in the resonator.

5. Acoustic structure according to one of claims 1 to 4, **characterized in that** it comprises means for attenuating spurious acoustic resonances in said second subset of layers.

6. Acoustic structure according to claim 5, **characterized in that** the attenuation means comprise at least one layer able to absorb the acoustic waves in the second subset of layers.

7. Acoustic structure according to one of claims 4 or 5, **characterized in that** the means for confining the acoustic waves in the resonator comprising a Bragg mirror structure, the second subset of layers does not comprise this structure for producing an attenuation of the said spurious acoustic resonances.

8. Acoustic structure according to claim 5, **characterized in that** the first subset of layers comprises a membrane structure situated under the active layer or layers of said resonator so as to form a resonant cavity.

9. Acoustic structure according to one of claims 1 to 8, **characterized in that** the ferroelectric material is made of BST.

10. Acoustic structure according to one of claims 1 to 9, **characterized in that** the piezoelectric material or materials of the first layer and/or of the second layer is (are) made of AIN.

11. Acoustic structure according to one of claims 1 to 10, **characterized in that** said structure comprises an upper passivation layer, which may be made of SiO₂.

12. Acoustic structure according to claim 11, **characterized in that** the modification of the stack in the second subset is produced in said passivation layer.

13. Acoustic structure according to one of claims 1 to 11, **characterized in that** the electrical insulation layer is made of SiO₂.

14. Acoustic structure according to one of claims 1 to 13, **characterized in that** the upper electrodes of the active layer in the first subset and in the second subset being produced in one and the same metallic subset of layers, the said modification of the stack in the said second subset is produced by an over-metallization of the said metallic subset.

15. Acoustic structure according to one of claims 1 to 14, **characterized in that** it comprises a bridge structure comprising two resonators (Rs₁, Rs₂) coupled electrically to two integrated capacitors (C_{c1}, C_{c2}).
